# FASCICULE DE BREVET EUROPEEN

(11) **EP 4 075 102 B1**
(45) Date de publication et mention de la délivrance du brevet: **03.04.2024**
(21) Numéro de dépôt: 22168643.9
(22) Date de dépôt: 15.04.2022
(51) Int. Cl.: G01D 4/00, G01F 1/00, G01F 15/061, G06Q 50/06, H03M 7/30

(54) **PROCÉDÉ DE COMMUNICATION DE LA CONSOMMATION DE FLUIDE MESURÉE PAR UN MODULE DE MESURE**
VERFAHREN ZUR KOMMUNIKATION DES VON EINEM MESSMODUL GEMESSENEN FLUIDVERBRAUCHS
METHOD FOR COMMUNICATING FLUID CONSUMPTION MEASURED BY A MEASURING MODULE

(30) Priorité: 15.04.2021 FR 2103886
(43) Date de publication de la demande: 19.10.2022
(73) Titulaire: Birdz, 92800 Puteaux (FR)
(72) Inventeur: VIEREN, Jean-Baptiste, 69005 LYON (FR); PAQUET, François, 38138 Les Côtes d'Arey (FR); VANDEKERCKHOVE, Arnauld, 33750 BARON (FR)
(74) Mandataire: Aquinov

(56) Documents cités:
- US-A1- 2006 202 855
- US-A1- 2010 321 205
- US-A1- 2020 196 031

## Description

L'invention concerne le domaine de l'analyse de la consommation d'un réseau de circulation d'un fluide. Plus précisément, l'invention concerne un procédé de communication de la consommation de fluide mesurée par un module de mesure pendant une pluralité de périodes temporelles.

Dans certains secteurs, il est nécessaire de connaitre chaque jour la consommation d'un réseau de circulation d'un fluide. C'est par exemple le cas pour un réseau hydraulique, pour lequel il est nécessaire de comptabiliser le volume d'eau consommé chaque jour au niveau de chacun des points de distribution locaux de ce réseau, comme par exemple dans le document US 2010/321205 A1.

Des instruments de comptage, ou autres instruments de mesure, sont ainsi implantés sur le lieu de consommation du fluide, par exemple au niveau d'une vanne contrôlant l'arrivée du fluide ou à l'entrée d'un secteur du réseau de distribution, afin de réaliser des relevés de consommation périodiques. Pour autant, les informations résultant de ces mesures doivent être exploitées à distance de ce lieu de consommation, par exemple pour facturer cette consommation, pour comprendre si la situation de consommation est normale ou requiert une action particulière ou encore pour procéder à une agglomération des données de l'ensemble du réseau afin de réaliser des études globales. A cet effet, ces relevés de consommation peuvent être transférés périodiquement sous forme numérisée, au travers de différents types de média, depuis le lieu de consommation jusqu'à l'emplacement de leur traitement distant.

Ce transfert d'information peut faire appel à des moyens de télécommunication qui, d'une part, n'offrent pas une capacité de transport de données suffisamment élevée compte tenu du nombre d'instruments de comptage ou de mesure opérant sur un même réseau et de la périodicité de ces mesures. D'autre part, ces moyens de télécommunication présentent des coûts énergétiques et économiques, auxquels peuvent se cumuler des coûts environnementaux, qui se doivent d'être maitrisés. Enfin, il est nécessaire de réduire la volumétrie et la durée des échanges pour améliorer le taux global de succès d'acheminement.

Dans ce contexte, il est essentiel de pouvoir obtenir, au niveau du lieu de traitement des informations, d'une information la plus complète possible quant à ces consommations périodiques, tant en termes de résolution qu'en termes de régularité, malgré les contraintes pesant sur ces moyens de communication. En particulier, il doit être pris en compte le fait que les media répondant à ces contraintes ont rarement des taux de perte de paquets nuls et qu'il est possible d'observer une perte d'information sur la connaissance de la consommation au niveau du réseau de distribution local pendant une ou plusieurs journée ou encore un mauvais ordonnancement de ces consommations au niveau du lieu de traitement.

Afin de pallier ces inconvénients, une première disposition peut consister en le renvoi, par l'instrument de comptage ou de mesure, du relevé de consommation qu'il a établi tant qu'un acquittement de réception n'est pas reçu. Si cette disposition permet de satisfaire le besoin de complétude d'information au niveau du lieu de traitement des informations, elle induit un inconvénient majeur qu'est l'augmentation sensible du trafic de messages sur le media avec de possibles collisions entre les messages des différents équipements utilisant le même media partagé. Cela induit aussi une plus forte consommation d'énergie, et un risque de ne pas respecter les règles d'usage du média et le taux d'occupation de la bande passante.

En outre, lorsque les moyens de télécommunications employés sont ponctuellement ou définitivement hors service, il est également constaté une perte d'information pendant une période de temps s'allongeant tant qu'une maintenance n'est pas réalisée, cette maintenance pouvant requérir un délai important. Il est ainsi nécessaire de pouvoir rattraper cette perte d'information, ce que ne permet pas cette première disposition.

Il existe ainsi un besoin pour un procédé de communication de la consommation de fluide mesurée par un module de mesure pendant une pluralité de périodes temporelles, qui permette d'obtenir, au niveau d'un terminal distant du module de mesure, une information la plus complète possible quant à cette consommation pendant ces périodes, malgré le fait que le média de transfert d'information présente une charge utile limitée et y compris en cas de perte de paquets ou d'indisponibilité d'une partie de ce média.

La présente invention se place dans ce contexte et vise à répondre à ce besoin.

A ces fins, l'invention a pour objet un procédé de communication de la consommation de fluide mesurée par un module de mesure pendant une pluralité de périodes temporelles, le procédé comportant les étapes suivantes :
a. Comptabilisation de toutes les consommations périodiques de fluide mesurées par le module de mesure ;
b. Encodage de la plus petite consommation périodique de fluide en une valeur initiale;
c. Encodage selon un même nombre de bits donné d'au moins l'une desdites consommations périodiques de fluide, en une valeur codée sensiblement égale à la différence entre cette consommation périodique de fluide et la valeur initiale ,
d. Concaténation de la valeur initiale et de l'ensemble des valeurs codées, triées chronologiquement, en une trame de données,
e. Transmission de ladite trame de données à un terminal distant du module de mesure à l'issue de la fin de la pluralité de périodes.

Selon l'invention, les consommations périodiques sont transmises au terminal distant à l'issue de chaque période, et sont réémises ensemble à l'issue de la fin de la pluralité des périodes. On vient ainsi redonder tout ou partie de l'information d'un message dans le ou les messages suivants, sans en attendre d'acquittement. Cette redondance d'information permet ainsi de rattraper une perte d'information due à une rupture ponctuelle de la liaison entre le module de mesure et le terminal distant destiné à recevoir cette information. En particulier, on peut ainsi retransmettre la consommation comptabilisée pendant la maintenance d'un relais ou d'un équipement du média ultérieurement cette maintenance. La compression de données dans cette trame de données, réalisée en exprimant au moins l'une des consommations périodiques vis-à-vis de la plus petite consommation périodique constatée, permet de diminuer la taille de la trame de données afin de respecter les contraintes du média et en particulier sa charge utile, tout en conservant une résolution de description des consommations qui soit satisfaisante. Il est ainsi possible d'augmenter le nombre de périodes temporelles décrites au sein d'une même trame, et donc d'augmenter la probabilité de pouvoir rattraper une perte ponctuelle d'information, la probabilité qu'une rupture ponctuelle d'une liaison soit réparée augmentant avec le temps. Enfin, l'ordonnancement chronologique des valeurs codées permet de fiabiliser le traitement de ces données au niveau du terminal distant, une consommation périodique d'une période donnée pouvant être retrouvée à partir de la position de la valeur codée correspondante dans la trame de données.

Selon l'invention, le procédé est mis en oeuvre par un dispositif d'analyse de la consommation d'un fluide d'un réseau de distribution dudit fluide, le dispositif étant équipé d'un module de mesure de la consommation dudit fluide par ledit réseau, d'un calculateur et d'une unité de communication sans-fil. Le module de mesure peut comporter un ou plusieurs capteurs ou instruments de mesure aptes à mesurer une ou plusieurs grandeurs physiques dont la valeur est fonction de la consommation de fluide par le réseau de distribution. Par exemple, le module pourra comporter une turbine, un compteur volumétrique et/ou un compteur de calories agencé sur une conduite du réseau de distribution destinée à véhiculer ledit fluide. Par exemple, l'unité de communication sans-fil est apte à émettre une trame de données sur un réseau de télécommunications à basse consommation, notamment de type LoRaWAN.

Avantageusement, chaque consommation périodique est transmise audit terminal distant à l'issue de la période pendant laquelle elle a été comptabilisée. Par exemple, la période de comptabilisation de la consommation par le module de mesure peut être d'un jour, et la pluralité de périodes peut être équivalente à un mois.

On entend notamment par « la plus petite consommation périodique de fluide » la consommation périodique, parmi toutes les consommations périodiques comptabilisées et de valeur non nulles, dont la valeur absolue est la plus petite.

Avantageusement, ladite consommation périodique de fluide est encodée en une valeur codée sensiblement égale, c'est-à-dire arrondie à une unité de consommation près, à la différence entre la valeur absolue de cette consommation périodique de fluide et la valeur initiale. Le cas échéant, une majorité desdites consommations périodiques de fluide peuvent être chacune encodée en une valeur codée sensiblement égale à la différence entre la valeur absolue de cette consommation périodique de fluide et la valeur initiale. Il a en effet été constaté que la majorité des consommations périodiques se concentre dans une plage de valeurs relativement resserrée, de sorte qu'il est possible de réaliser une compression de données en décrivant chacune de ces consommations relativement à la plus petite d'entre elles.

De préférence, le procédé peut comporter une étape de détermination du signe privilégié de consommation en fonction du nombre de consommations positives et négatives, pendant ladite pluralité de périodes, ce signe étant encodé en une valeur de signe, laquelle est concaténée à la trame de données. Il a en effet été constaté que les instruments de mesure employés dans les dispositifs d'analyse de consommation, comme les compteurs d'eau, peuvent établir des relevés de consommation parfois négatifs, par exemple lorsqu'ils ont été montés à l'envers après un remplacement ou une maintenance. Cette caractéristique permet de pallier ce problème.

Par exemple, ledit signe privilégié peut être déterminé en fonction du nombre de consommations périodiques de signe positif et du nombre de consommations périodiques de signe négatif parmi l'ensemble des consommations périodiques comptabilisées. Dans un exemple de réalisation de l'invention, le signe privilégié peut être le signe des consommations périodiques majoritairement de même signe parmi l'ensemble des consommations périodiques comptabilisées. En variante, ledit signe privilégié peut être un signe négatif si toutes les consommations périodiques de l'ensemble des consommations périodiques comptabilisées sont de signe négatif et un signe positif si au moins l'une des consommations périodiques parmi l'ensemble des consommations périodiques comptabilisées est de signe positif. Le cas échéant, ladite plus petite consommation périodique de fluide est celle, parmi les consommations périodiques de fluide de même signe que ce signe privilégié, dont la valeur absolue est la plus petite.

Avantageusement, le nombre de valeurs codées disponibles pour l'encodage des consommations périodiques de même signe que ledit signe privilégié, est supérieur au nombre de valeurs codées disponibles pour l'encodage des consommations périodiques de signe opposé audit signe privilégié. On entend par « valeurs codées disponibles » l'ensemble des valeurs pouvant être décrites de façon binaire selon ledit nombre de bits donné.

De préférence, chaque consommation périodique de valeur nulle est encodée en une valeur codée nulle.

Dans un mode de réalisation de l'invention, une première borne est définie au préalable comme une valeur codée maximale disponible pour l'encodage des consommations périodiques de même signe que ledit signe privilégié. Le cas échéant, pour chaque consommation périodique de même signe que ledit signe privilégié, si la valeur absolue de cette consommation périodique est comprise entre la valeur initiale et la somme de la valeur initiale et de la première borne, cette consommation périodique est encodée à une valeur codée sensiblement égale à la différence entre sa valeur absolue et la valeur initiale. Par exemple, la première borne étant fixée à 4000 (pour 12 bits), la plage de consommations périodiques s'étendant entre la valeur initiale et la valeur initiale additionnée de 3999 peut être encodée sur une plage de valeurs codées s'étendant entre 1 et 4000.

Avantageusement, une deuxième borne, supérieure à la première borne, est définie au préalable comme une valeur codée maximale disponible pour l'encodage des consommations périodiques de signe opposé audit signe privilégié. Le cas échéant, pour chaque consommation périodique de signe opposé audit signe privilégié, si la valeur absolue de cette consommation périodique est inférieure à la différence entre la deuxième borne et la première borne, cette consommation périodique est encodée à une valeur codée sensiblement égale à la somme de sa valeur absolue et la première borne. Par exemple, la première borne étant fixée à 4092 (pour 12 bits), la plage de consommations périodiques s'étendant entre -92 et -1 peut être encodée sur une plage de valeurs codées s'étendant entre 4001 et 4092.

De préférence, pour chaque consommation périodique de signe opposé audit signe privilégié, si la valeur absolue de cette consommation périodique est supérieure à la différence entre la deuxième borne et la première borne, cette consommation périodique est encodée à une valeur codée supérieure à la deuxième borne distincte. Par exemple, cette valeur codée sera de 4093, quelle que soit la valeur de cette consommation périodique. Selon cette caractéristique, si une consommation périodique de signe opposé sort de la plage de valeur pour laquelle un encodage est possible, seule une indication quant à l'amplitude de cette consommation est réellement décrite dans la trame de données, et il est accepté une perte d'information dans la compression dans la mesure où la valeur réelle de cette consommation n'a que peu d'intérêt et dans la mesure où de telles consommations sont peu probable.

Avantageusement, si la valeur absolue de la plus grande consommation périodique de même signe que ledit signe privilégié est supérieure à la somme de la valeur initiale et de la première borne, cette consommation périodique est encodée à une valeur codée supérieure à la deuxième borne distincte, et la différence entre sa valeur absolue et la somme de la valeur initiale et de la première borne est encodée dans une valeur de dépassement qui est concaténée à la trame de données. Par exemple, cette valeur codée sera de 4094. Selon cette caractéristique, pour cette plus grande consommation de même signe, on accepte un dépassement en dehors de la plage de codage réservé en indiquant, dans la trame de données, qu'il s'agit d'un dépassement, et en ajoutant dans la trame de données, à la suite de l'ensemble des valeurs codées, une valeur de dépassement de cette consommation vis-à-vis de la somme de la valeur initiale et de la première borne.

Le cas échéant, pour chaque consommation périodique de même signe que le signe privilégié, si la valeur absolue de cette consommation périodique est comprise entre la somme de la valeur initiale et de la première borne et la valeur absolue de la plus grande consommation périodique de même signe que ledit signe privilégié, cette consommation périodique pourra être encodée à une valeur codée supérieure à la deuxième borne distincte. Si on le souhaite, cette valeur codée pourra être identique à celle codant les consommations périodiques de signe opposé et dont la valeur absolue de cette consommation périodique est supérieure à la différence entre la deuxième borne et la première borne. En variante, ces deux valeurs codées pourront être distinctes.

Avantageusement, les étapes de comptabilisation, d'encodage, de concaténation et de transmission sont renouvelées pour chaque nouvelle pluralité de périodes temporelles. Le cas échéant, ladite trame de données est transmise au terminal distant à plusieurs reprises dans la pluralité de périodes temporelles suivantes.

Dans un exemple de réalisation de l'invention, ladite plus petite consommation périodique est encodée sur une valeur initiale de 14 bits, chaque consommation périodique est encodée sur une valeur codée de 12 bits, le signe privilégié est encodé sur 1 bit et la valeur de dépassement est encodée sur 9 bits.

L'invention a également pour objet un dispositif d'analyse de la consommation d'un fluide d'un réseau de distribution dudit fluide, le dispositif comprenant un module de mesure de la consommation dudit fluide par ledit réseau, un calculateur et un module de communication sans-fil, le dispositif étant agencé pour mettre en oeuvre le procédé selon l'invention.

Avantageusement, le calculateur est équipé d'une mémoire et est agencé pour stocker chacune des consommations périodiques comptabilisées par le module de mesure dans cette mémoire et pour mettre en oeuvre les étapes d'encodage et de concaténation du procédé selon l'invention.

De préférence, le fluide est un liquide, et notamment de l'eau. En variante, le fluide est un gaz.

Avantageusement toujours, le dispositif d'analyse est un compteur d'eau.

La présente invention est maintenant décrite à l'aide d'exemples uniquement illustratifs et nullement limitatifs de la portée de l'invention, et à partir des dessins annexés, dessins sur lesquels les différentes figures représentent :
[fig.1] représente, schématiquement et partiellement, une vanne équipée d'un dispositif d'analyse de la consommation d'un fluide de la vanne selon un mode de réalisation de l'invention ;
[fig.2] représente, schématiquement et partiellement, un procédé de suivi de la consommation de fluide de la vanne de la [fig.1] selon un mode de réalisation de l'invention ;
[fig.3] représente, schématiquement et partiellement, un relevé de consommation de fluide de la vanne de la [fig.1] et une trame de données décrivant ce relevé et obtenue au moyen du procédé de la [fig.2].

Dans la description qui suit, les éléments identiques, par structure ou par fonction, apparaissant sur différentes figures conservent, sauf précision contraire, les mêmes références.

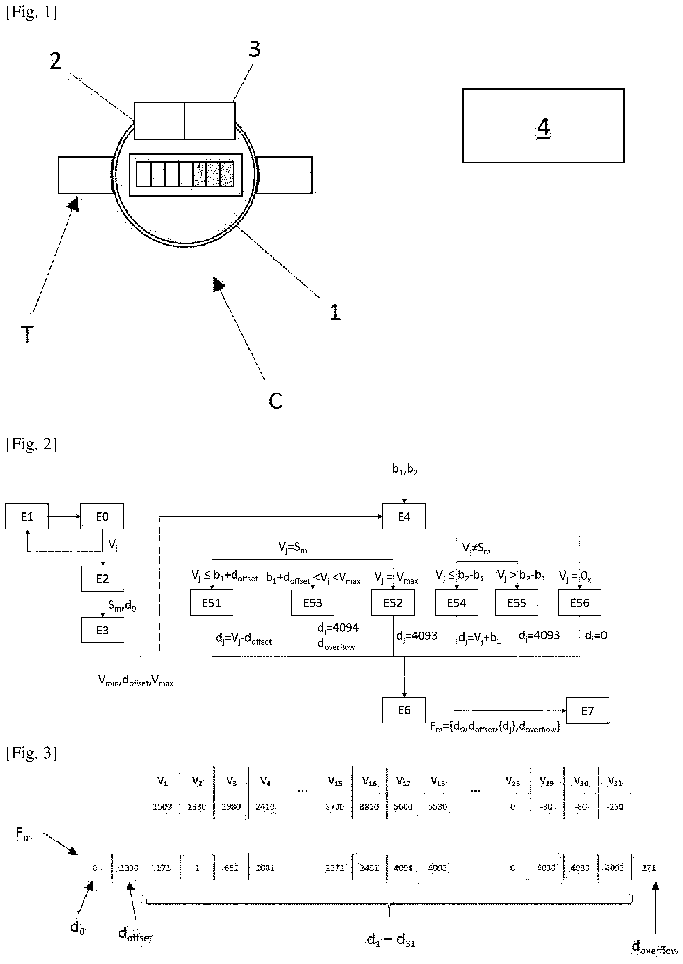

On a représenté en [fig.1] un compteur d'eau C d'un réseau de distribution hydraulique selon un mode de réalisation de l'invention. Le compteur d'eau C est monté sur une canalisation T raccordant un réseau principal de distribution d'eau à un réseau secondaire local de distribution.

Le compteur C comportant un module de mesure 1 de la consommation d'eau par le réseau secondaire. Ce module de mesure pourra par exemple comporter des ailettes (non représentées) agencées dans la canalisation T ainsi qu'un compteur des tours effectués par ces ailettes lorsqu'elles sont entrainées par le fluide passant par la canalisation T. Ce compteur de tour permet ainsi de mesurer la consommation d'eau de façon journalière.

Le compteur C comporte également un calculateur 2 et une unité de communication sans-fil 3 apte à échanger des données, par exemple via un réseau de télécommunication à basse consommation de type LoRaWan, avec un terminal 4 distant du compteur C. Le terminal distant 4 peut par exemple être une unité de traitement de données d'un opérateur de service ou d'un gestionnaire de parc.

Le compteur C est ainsi agencé pour mettre en oeuvre un procédé de communication de la consommation journalière mesurée par le compteur C pendant un mois avec le terminal distant 4. Un exemple de réalisation de ce procédé selon l'invention va être décrit en liaison avec la [fig.2].

Dans une étape E0 réalisée de façon continue, la consommation journalière Vⱼ du jour j est mesurée par le module de mesure 1.

Dans une étape E1, à l'issue de chaque jour j, cette consommation journalière Vⱼ est transmise, via l'unité de communication sans-fil 3, au terminal distant 4. Cette consommation journalière Vⱼ est également stockée dans une mémoire du calculateur 2.

Dans une étape E2, à l'issue du mois m qui s'est écoulé, le calculateur 2 détermine le signe privilégié Sₘ de consommation pendant ce mois m. A cet effet, le calculateur 2 détermine le nombre de consommations journalières Vⱼ positives et le nombre de consommations journalières Vⱼ négatives et détermine le signe privilégié Sₘ en fonction de ces nombres. Si le nombre de consommations journalières Vⱼ positives est nul, et qu'en d'autres termes, toutes les consommations journalières Vⱼ sont négatives le signe Sₘ est un signe négatif. Si au moins l'une des consommations journalières Vⱼ est positive, le signe Sₘ est un signe positif. Ce signe Sₘ est encodé par le calculateur 2 dans une donnée d₀ sur un bit. Par exemple, un signe privilégié positif peut être encodé par un bit de valeur 0 et un signe privilégié négatif peut être encodé par un bit de valeur 1.

Dans une étape E3, parmi l'ensemble des consommations journalières Vⱼ de signe identique au signe privilégié Sₘ, le calculateur 2 détermine quelle est la plus petite consommation journalière Vₘᵢₙ. Compte tenu du fait que ces consommations journalières Vⱼ de signe identique peuvent être positives ou négatives, le calculateur 2 calculera Vₘᵢₙ en déterminant quelle est la consommation journalière Vⱼ de signe identique au signe privilégié Sₘ dont la valeur absolue est la plus petite. Cette valeur V ₘᵢₙ est encodée par le calculateur 2 dans une donnée d_{offset} sur 14 bits.

Dans l'étape E3, parmi l'ensemble des consommations journalières Vⱼ de signe identique au signe privilégié Sₘ, le calculateur 2 détermine, de façon similaire, quelle est la plus grande consommation journalière Vₘₐₓ.

Par la suite, dans une étape E4, chacune des consommations journalières Vⱼ est lue par le calculateur 2 et subit différentes comparaisons afin d'être encodée sur un nombre de bits donné, par exemple 12 bits. Cette étape E4 est renouvelée pour chacune des consommations journalières Vⱼ.

Au préalable, une première borne b₁ a été fixée pour définir une plage de données permettant de décrire, sur 12 bits, une plage donnée de consommations journalières de même signe que le signe privilégié Sₘ. En d'autres termes, la première borne b₁ définit une valeur maximale d'une plage de valeurs [1,b₁] disponibles pour l'encodage de certaines consommations journalières. De même, une deuxième borne b₂ a été fixée pour définir une plage de données permettant de décrire, sur 12 bits, une plage donnée de consommations journalières de signe opposé au signe privilégié Sₘ. En d'autres termes, la deuxième borne b₂ définit une valeur maximale d'une plage de valeurs [b₁ +1,b_{2]} disponibles pour l'encodage de certaines consommations journalières. Les bornes b₁ et b₂ sont choisies de sorte que le nombre de données disponibles dans la plage [1,b_{1]} soit supérieur au nombre de données disponibles dans la plage [b₁+1,b₂]. Dans l'exemple décrit, la borne b₁ est fixée à 4000 et la borne b₂ est fixée à 4092.

Dans le cas où le signe de la consommation journalière Vⱼ, traitée dans l'étape E4, est identique au signe privilégié Sₘ, le calculateur 2 compare la valeur absolue de cette consommation journalière Vⱼ à la somme b₁+ d_{offset}, ainsi qu'à la valeur Vₘₐₓ.

Si cette valeur absolue est comprise entre d_{offset} et b₁+d_{offset}, la consommation journalière Vⱼ est encodée, dans une étape E51, en une valeur codée dⱼ sensiblement égale à la différence |Vⱼ| - d_{offset}. Cette valeur codée dⱼ se trouve ainsi dans la plage [1,b₁ ].

Si cette valeur absolue est supérieure à b₁+ d_{offset} et est égal à Vₘₐₓ, la consommation journalière Vⱼ est encodée, dans une étape E52, en une valeur codée dⱼ réservée à cet effet et supérieure à la deuxième borne b₂, par exemple 4094. Par ailleurs, le dépassement de cette valeur absolue vis-à-vis de la somme b₁ + d_{offset}, est encodé en une valeur de dépassement d_{overflow}, sur 9 bits. En d'autres termes, cette valeur de dépassement d_{overflow} est sensiblement égale à |Vⱼ| - d_{offset} - b₁.

Enfin, si cette valeur absolue est supérieure à b₁+ d_{offset} et est inférieure à Vₘₐₓ, la consommation journalière V; est encodée, dans une étape E53, en une autre valeur codée dⱼ réservée à cet effet et supérieure à la deuxième borne b₂, par exemple 4093.

Dans le cas où le signe de la consommation journalière Vⱼ, traitée dans l'étape E4, est opposé au signe privilégié Sₘ, le calculateur 2 compare la valeur absolue de cette consommation journalière Vⱼ à la différence b₂ - b₁.

Si cette valeur absolue est inférieure ou égale à b₂- b₁, la consommation journalière V ⱼ est encodée, dans une étape E54, en une valeur codée dⱼ sensiblement égale à la somme |Vⱼ| + b₁. Cette valeur codée dⱼ se trouve ainsi dans la plage [b₁+1,b₂].

Enfin, si cette valeur absolue est supérieure à b₂- b₁, la consommation journalière Vⱼ est encodée, dans une étape E55, en une autre valeur codée dⱼ réservée à cet effet et supérieure à la deuxième borne b₂, par exemple également égale à 4093.

Par ailleurs, dans le cas où la consommation journalière Vⱼ, traitée dans l'étape E4, est nulle, elle est encodée en une valeur nulle.

Lorsque l'intégralité des consommations journalières Vⱼ ont été encodées, le contrôleur 2 concatène, dans une étape E6, la donnée d₀, donnée d_{offset}, l'ensemble des valeurs codées dⱼ triées chronologiquement, c'est-à-dire selon leur indice j, et le cas échéant, la valeur de dépassement d_{overflow} en une trame de données Fₘ associée au mois m. Un identifiant de ce mois m, par exemple codé sur 8 bits, est ajouté au début de la trame.

Enfin, dans une étape E7, la trame de données Fm est transmise, via l'unité de communication sans-fil 3, au terminal distant. Dans cette étape E7, la trame de données Fₘ est transmise une première fois, au début du mois suivant m+1, puis à plusieurs reprises pendant ce mois m+1, afin d'introduire de la redondance supplémentaire.

Il est à noter que les étapes E0 à E7 sont renouvelées pendant ce mois suivant m+1, afin de pouvoir transmettre le mois d'après une trame de données Fₘ₊₁ décrivant, selon la même méthode de compression, les consommations journalières de ce mois suivant.

On a décrit en [fig.3] un exemple de relevé de consommations journalières V₁ à V₃₁, mesurées par le compteur C pendant un mois donné, et une trame de données Fₘ décrivant ces consommations et obtenue au moyen du procédé de la [fig.2].

On constate notamment que le signe privilégié Sₘ de ces consommations est positif, la donnée d₀ étant par conséquent un bit nul.

La plus petite consommation journalière positive Vₘᵢₙ identifiée est la consommation V₂, encodée dans la donnée d_{offset}. Les consommations journalières positives sont ainsi décrites relativement à cette donnée d_{offset}. C'est notamment le cas des consommations V₁ à V₁₆.

En revanche, la plus grande consommation journalière positive Vⱼ, à savoir V₁₇, est supérieure à d_{offset} + 4000. Elle est donc décrite au moyen du code 4094, et une donnée d_{overflow} est ainsi présente à la fin de la trame Fₘ. On note également que V₁₈ est comprise entre d_{offset} + 4000 et V₁₇. Elle est donc seulement décrite au moyen du code 4093.

La consommation V₂₈ étant nulle, la valeur d₂₈ est également nulle.

Enfin, les consommations journalières V₂₉ et V₃₀ sont négatives, bien qu'inférieures en valeur absolue à 98. Elles sont donc décrites, dans les valeurs d₂₉ et d₃₀, par la somme de la première borne, 4000, et de leur valeur absolue. A l'inverse, V₃₁, est supérieure en valeur absolue à 98. Elle est donc seulement décrite au moyen du code 4093.

On constate ainsi que ces consommations journalières V₁ à V₃₁, sont décrites de manière compressée dans la trame de données Fₘ, de sorte qu'il est possible d'ajouter de la redondance aux émissions de ces valeurs lors des étapes E1 du procédé de la [fig.1], tout en respectant les contraintes imposées par le réseau de télécommunication permettant l'échange de données entre le compteur C et le terminal distant 4.

Dans le cas où l'une ou plusieurs de ces consommations journalières n'auraient pas été reçues par le terminal distant 4, par exemple du fait d'une perte de paquet ou d'une maintenance d'un relais de ce réseau, cette redondance permet au terminal distant de récupérer cette ou ces consommations journalières.

La description qui précède explique clairement comment l'invention permet d'atteindre les objectifs qu'elle s'est fixée, à savoir obtenir, au niveau d'un terminal distant du module de mesure, une information la plus complète possible quant à la consommation de fluide mesurée par un module de mesure pendant une pluralité de périodes, malgré le fait que le média de transfert d'information entre le module de mesure et le terminal distant présente une charge utile limitée et y compris en cas de perte de paquets ou d'indisponibilité d'une partie de ce média.

En tout état de cause, l'invention ne saurait se limiter aux modes de réalisation spécifiquement décrits dans ce document, et s'étend en particulier à tous moyens équivalents et à toute combinaison techniquement opérante de ces moyens. On pourra en particulier envisager d'autres types de compression que celles décrites.

## Revendications

1. Procédé de communication de la consommation de fluide mesurée par un module de mesure (1) pendant une pluralité (m) de périodes temporelles (j), le procédé comportant les étapes suivantes :
a. (E0, E1) Comptabilisation de toutes les consommations périodiques (Vⱼ) de fluide mesurées par le module de mesure ;
b. (E3) Encodage de la plus petite consommation périodique (V ₘᵢₙ) de fluide en une valeur initiale (d_{offset});
c. (E4, E51) Encodage selon un même nombre de bits donné d'au moins l'une desdites consommations périodiques de fluide en une valeur codée (dⱼ) sensiblement égale à la différence entre cette consommation périodique de fluide et la valeur initiale ;
d. (E6) Concaténation de la valeur initiale et de l'ensemble des valeurs codées, triées chronologiquement, en une trame de données (Fₘ) ;
e. (E7) Transmission de ladite trame de données à un terminal distant du module de mesure à l'issue de la fin de la pluralité de périodes.

2. Procédé selon la revendication précédente, le procédé comportant une étape (E2) de détermination du signe privilégié (Sₘ) de consommation en fonction du nombre de consommations (Vⱼ) positives et négatives, pendant ladite pluralité (m) de périodes (j), ce signe étant encodé en une valeur de signe (d₀), laquelle est concaténée à la trame de données (Fₘ).

3. Procédé selon la revendication précédente, dans lequel le nombre de valeurs codées disponibles pour l'encodage des consommations périodiques (Vⱼ) de même signe que ledit signe privilégié (Sₘ), est supérieur au nombre de valeurs codées disponibles pour l'encodage des consommations périodiques de signe opposé audit signe privilégié.

4. Procédé selon l'une des revendications 2 ou 3, dans lequel une première borne (b₁) est définie au préalable comme une valeur codée maximale disponible pour l'encodage des consommations périodiques (Vⱼ) de même signe que ledit signe privilégié (Sₘ), et dans lequel, pour chaque consommation périodique de même signe que ledit signe privilégié, si la valeur absolue de cette consommation périodique est comprise entre la valeur initiale (d_{offset}) et la somme de la valeur initiale et de la première borne, cette consommation périodique est encodée à une valeur codée (d ⱼ) sensiblement égale à la différence entre sa valeur absolue et la valeur initiale.

5. Procédé selon la revendication précédente, dans lequel une deuxième borne (b₂), supérieure à la première borne (b₁), est définie au préalable comme une valeur codée maximale disponible pour l'encodage des consommations périodiques (Vⱼ) de signe opposé audit signe privilégié (Sₘ), et dans lequel, pour chaque consommation périodique de signe opposé audit signe privilégié, si la valeur absolue de cette consommation périodique est inférieure à la différence entre la deuxième borne et la première borne, cette consommation périodique est encodée à une valeur codée (dⱼ) sensiblement égale à la somme de sa valeur absolue et la première borne.

6. Procédé selon la revendication précédente, dans lequel, pour chaque consommation périodique (Vⱼ) de signe opposé audit signe privilégié (S ₘ), si la valeur absolue de cette consommation périodique est supérieure à la différence entre la deuxième borne (b₂) et la première borne (b₁), cette consommation périodique est encodée à une valeur codée (dⱼ) supérieure à la deuxième borne distincte.

7. Procédé selon l'une des revendications 5 ou 6, dans lequel, si la valeur absolue de la plus grande consommation périodique (Vₘₐₓ) de même signe que ledit signe privilégié (Sₘ) est supérieure à la somme de la valeur initiale (d_{offset}) et de la première borne (b₁), cette consommation périodique est encodée à une valeur codée (dⱼ) supérieure à la deuxième borne distincte, et la différence entre sa valeur absolue et la somme de la valeur initiale et de la première borne est encodée dans une valeur de dépassement (d_{overflow}) qui est concaténée à la trame de données (Fₘ).

8. Procédé selon l'une des revendications 5 à 7, dans lequel, pour chaque consommation périodique (Vⱼ) de même signe que le signe privilégié (S ₘ), si la valeur absolue de cette consommation périodique est comprise entre la somme de la valeur initiale (d_{offset}) et de la première borne (b₁) et la valeur absolue de la plus grande consommation périodique (Vₘₐₓ) de même signe que ledit signe privilégié, cette consommation périodique est encodée à une valeur codée (dⱼ) supérieure à la deuxième borne distincte (b₂).

9. Procédé selon l'une des revendications précédentes, dans lequel les étapes de comptabilisation (E0, E1), d'encodage (E3, E4, E51), de concaténation (E6) et de transmission (E7) sont renouvelées pour chaque nouvelle pluralité (m) de périodes temporelles (j).

10. Dispositif (C) d'analyse de la consommation d'un fluide d'un réseau de distribution dudit fluide, le dispositif comprenant un module de mesure (1) de la consommation dudit fluide par ledit réseau, un calculateur (2) et un module de communication sans-fil (3), le dispositif étant agencé pour mettre en oeuvre le procédé selon l'une des revendications précédentes.

## Patentansprüche

1. Verfahren zum Kommunizieren des Fluidverbrauchs, der durch ein Messmodul (1) während einer Vielzahl (m) von Zeitperioden (j) gemessen wird, wobei das Verfahren die folgenden Schritte aufweist:
a. (E0, E1) Erfassen aller periodischen Fluidverbräuche (Vⱼ), die durch das Messmodul gemessen werden;
b. (E3) Codieren des kleinsten periodischen Fluidverbrauchs (Vₘᵢₙ) zu einem Anfangswert (d_{offset});
c. (E4, E51) Codieren gemäß einer selben gegebenen Bitanzahl mindestens eines der periodischen Fluidverbräuche zu einem codierten Wert (dⱼ), der im Wesentlichen gleich dem Unterschied zwischen dem periodischen Fluidverbrauch und dem Anfangswert ist;
d. (E6) Verketten des Anfangswerts und der Gesamtheit der chronologisch sortierten codierten Werte zu einem Datenrahmen (Fₘ);
e. (E7) Übertragen des Datenrahmens an ein Endgerät, das von dem Messmodul entfernt ist, nach dem Ende der Vielzahl von Perioden.

2. Verfahren nach dem vorstehenden Anspruch, wobei das Verfahren einen Schritt (E2) eines Bestimmens des bevorzugten Verbrauchszeichens (Sₘ) in Abhängigkeit von der Anzahl von positiven und negativen Verbräuchen (Vⱼ) während der Vielzahl (m) von Perioden (j) umfasst, wobei dieses Zeichen zu einem Zeichenwert (d₀) codiert ist, der mit dem Datenrahmen (Fₘ) verkettet ist.

3. Verfahren nach dem vorstehenden Anspruch, wobei die Anzahl von codierten Werten, die zum Codieren von periodischen Verbräuchen (Vⱼ) mit demselben Zeichen wie das bevorzugte Zeichen (Sₘ) verfügbar sind, größer als die Anzahl von codierten Werten ist, die zum Codieren von periodischen Verbräuchen mit dem Zeichen verfügbar sind, das dem bevorzugten Zeichen entgegengesetzt ist.

4. Verfahren nach einem der Ansprüche 2 oder 3, wobei eine erste Grenze (b₁) zuvor als ein maximaler codierter Wert definiert wird, der zum Codieren von periodischen Verbräuchen (Vⱼ) mit demselben Zeichen wie das bevorzugte Zeichen (Sₘ) verfügbar ist, und wobei, für jeden periodischen Verbrauch mit demselben Zeichen wie das bevorzugte Zeichen, wenn der Absolutwert dieses periodischen Verbrauchs zwischen dem Anfangswert (d_{offset}) und der Summe des Anfangswerts und der ersten Grenze liegt, dieser periodische Verbrauch zu einem codierten Wert (dⱼ) codiert wird, der im Wesentlichen gleich dem Unterschied zwischen seinem Absolutwert und dem Anfangswert ist.

5. Verfahren nach dem vorstehenden Anspruch, wobei eine zweite Grenze (b₂) über der ersten Grenze (b₁) zuvor als ein maximaler codierter Wert definiert wird, der zum Codieren von periodischen Verbräuchen (Vⱼ) mit dem Zeichen verfügbar ist, das dem bevorzugten Zeichen (Sₘ) entgegengesetzt ist, und wobei, für jeden periodischen Verbrauch mit dem Zeichen, das dem bevorzugten Zeichen entgegengesetzt ist, wenn der Absolutwert dieses periodischen Verbrauch kleiner als der Unterschied zwischen der zweiten Grenze und der ersten Grenze ist, dieser periodische Verbrauch zu einem codierten Wert (dⱼ) codiert wird, der im Wesentlichen gleich der Summe seines Absolutwerts und der ersten Grenze ist.

6. Verfahren nach dem vorstehenden Anspruch, wobei für jeden periodischen Verbrauch (Vⱼ) mit dem Zeichen, das dem bevorzugten Zeichen (Sₘ) entgegengesetzt ist, wenn der Absolutwert dieses periodischen Verbrauchs über dem Unterschied zwischen der zweiten Grenze (b₂) und der ersten Grenze (b₁) ist, dieser periodische Verbrauch zu einem separaten codierten Wert d(ⱼ) codiert wird, der über der zweiten Grenze liegt.

7. Verfahren nach einem der Ansprüche 5 oder 6, wobei, wenn der Absolutwert des größten periodischen Verbrauchs (Vₘₐₓ) mit demselben Zeichen wie das bevorzugte Zeichen (Sₘ) über der Summe des Anfangswerts (d_{offset}) und der ersten Grenze (b₁) liegt, dieser periodische Verbrauch zu einem separaten codierten Wert (dⱼ) codiert wird, der über der zweiten Grenze liegt, und der Unterschied zwischen seinem Absolutwert und der Summe des Anfangswerts und der ersten Grenze zu einem Überschreitungswert (d_{overflow}) codiert wird, der mit dem Datenrahmen (Fₘ) verkettet ist.

8. Verfahren nach einem der Ansprüche 5 bis 7, wobei für jeden periodischen Verbrauch (Vⱼ) mit demselben Zeichen wie das bevorzugte Zeichen (Sₘ), wenn der Absolutwert dieses periodischen Verbrauchs zwischen der Summe des Anfangswerts (d_{offset}) und der ersten Grenze (b₁) und dem Absolutwert des größten periodischen Verbrauchs (Vₘₐₓ) mit demselben Zeichen wie das bevorzugte Zeichen liegt, dieser periodische Verbrauch zu einem separaten codierten Wert (dⱼ) über der zweiten Grenze (b₂) codiert wird.

9. Verfahren nach einem der vorstehenden Ansprüche, wobei die Schritte des Erfassens (E0, E1), des Codierens (E3, E4, E51), des Verkettens (E6) und des Übertragens (E7) für jede neue Vielzahl (m) von zeitlichen Perioden (j) wiederholt werden.

10. Vorrichtung (C) zum Analysieren des Verbrauchs eines Fluids eines Verteilungsnetzes des Fluids, die Vorrichtung umfassend ein Modul (1) zum Messen des Verbrauchs des Fluids durch das Netz, einen Rechner (2) und ein Drahtloskommunikationsmodul (3), wobei die Vorrichtung zum Implementieren des Verfahrens nach einem der vorstehenden Ansprüche eingerichtet ist.

## Claims

1. A method for communicating the fluid consumption measured by a measurement module (1) over a plurality (m) of time periods (j), the method comprising the following steps:
a. (EC, E1) counting up all of the periodic fluid consumptions (Vⱼ) measured by the measurement module;
b. (E3) encoding the smallest periodic fluid consumption (Vₘᵢₙ) as an initial value (d_{offset});
c. (E4, E51) encoding, with the same given number of bits, at least one of said periodic fluid consumptions as a coded value (dⱼ) that is substantially equal to the difference between this periodic fluid consumption and the initial value;
d. (E6) concatenating the initial value and all of the coded values, ordered chronologically, in a dataframe (Fₘ);
e. (E7) transmitting the dataframe to a remote terminal, remote from the measurement module, at the end of the plurality of periods.

2. The method as claimed in the preceding claim, wherein the method comprises a step (E2) of determining the favored consumption sign (Sₘ) according to the number of positive and negative consumptions (Vⱼ) over the plurality (m) of periods (j), this sign being encoded as a sign value (d₀) which is concatenated to the dataframe (Fₘ).

3. The method as claimed in the preceding claim, wherein the number of coded values available for the encoding of the periodic consumptions (Vⱼ) of the same sign as said favored sign (Sₘ) is greater than the number of coded values available for the encoding of the periodic consumptions of the opposite sign to said favored sign.

4. The method as claimed in either of claims 2 and 3, wherein a first bound (b₁) is defined beforehand as a maximum coded value available for the encoding of the periodic consumptions (Vⱼ) of the same sign as said favored sign (Sₘ) and wherein, for each periodic consumption of the same sign as said favored sign, if the absolute value of this periodic consumption is between the initial value (d_{offset}) and the sum of the initial value and of the first bound, this periodic consumption is encoded to a coded value (dⱼ) that is substantially equal to the difference between its absolute value and the initial value.

5. The method as claimed in the preceding claim, wherein a second bound (b₂), greater than the first bound (b₁), is defined beforehand as a maximum coded value available for the encoding of the periodic consumptions (Vⱼ) of the opposite sign to said favored sign (Sₘ) and wherein, for each periodic consumption of the opposite sign to said favored sign, if the absolute value of this periodic consumption is smaller than the difference between the second bound and the first bound, this periodic consumption is encoded to a coded value (dⱼ) that is substantially equal to the sum of its absolute value and the first bound.

6. The method as claimed in the preceding claim, wherein, for each periodic consumption (Vⱼ) of the opposite sign to said favored sign (Sₘ), if the absolute value of this periodic consumption is greater than the difference between the second bound (b₂) and the first bound (b₁), this periodic consumption is encoded to a separate coded value (dⱼ) that is greater than the second bound.

7. The method as claimed in either of claims 5 and 6, wherein, if the absolute value of the largest periodic consumption (Vₘₐₓ) of the same sign as said favored sign (Sₘ) is greater than the sum of the initial value (d_{offset}) and of the first bound (b₁), this periodic consumption is encoded to a separate coded value (dⱼ) that is greater than the second bound, and the difference between its absolute value and the sum of the initial value and of the first bound is encoded in an overflow value (d_{overflow}) which is concatenated to the dataframe (Fₘ).

8. The method as claimed in one of claims 5 to 7, wherein, for each periodic consumption (Vⱼ) of the same sign as said favored sign (Sₘ), if the absolute value of this periodic consumption is between the sum of the initial value (d_{offset}) and of the first bound (b₁) and the absolute value of the largest periodic consumption (Vₘₐₓ) of the same sign as said favored sign, this periodic consumption is encoded to a separate coded value (dⱼ) that is greater than the second bound (b₂).

9. The method as claimed in one of the preceding claims, wherein the steps of counting up (E0, E1), of encoding (E3, E4, E51), of concatenating (E6) and of transmitting (E7) are repeated for each new plurality (m) of time periods (j).

10. A device (C) for analyzing the consumption of a fluid in a distribution network for said fluid, the device comprising a measurement module (1) for measuring the consumption of said fluid by said network, a computer (2) and a wireless communication module (3), the device being arranged so as to implement the method as claimed in one of the preceding claims.
